Europäisches Patentamt

European Patent Office

Office européen des brevets

(11) Publication number: **0 046 629**
**B1**

# EUROPEAN PATENT SPECIFICATION

(45) Date of publication of patent specification: **11.03.87**

(21) Application number: **81302758.8**

(22) Date of filing: **18.06.81**

(51) Int. Cl.⁴: **H 01 L 27/10, H 01 L 21/90,
G 11 C 11/24**

(54) **Semi-conductor memory device having an insulated gate field effect transistor as a fundamental element.**

(30) Priority: **07.07.80 JP 93461/80**

(43) Date of publication of application:
**03.03.82 Bulletin 82/09**

(45) Publication of the grant of the patent:
**11.03.87 Bulletin 87/11**

(84) Designated Contracting States:
**DE FR GB**

(56) References cited:
**US-A-4 163 243**

**IBM TECHNICAL DISCLOSURE BULLETIN, vol.
21, no. 9, February 1979, pages 3828-3831, New
York (USA); V.L.RIDEOUT: "Double polysilicon
dynamic memory cell with polysilicon bit line"**

**IEEE TRANSACTION ON ELECTRON DEVICES,
vol. ED-26, no. 6, June 1979, pages 839-851;
V.L.RIDEOUT: "One-device cells for dynamic
random-access memories: A tutorial"**

**PATENTS ABSTRACTS OF JAPAN, vol. 2, no. 4,
12th January 1978, page 9817 E 77;**

(73) Proprietor: **MITSUBISHI DENKI KABUSHIKI
KAISHA
2-3, Marunouchi 2-chome Chiyoda-ku
Tokyo 100 (JP)**

(72) Inventor: **Shimotori, Kazuhiro
11-1-906, Toneyama 6-chome
Toyonaka-shi Osaka-hu (JP)**
Inventor: **Ozaki, Hideyuki Mitsubishi Denki
Kabushiki Kaisha
Senshin Ryo 4-35, Suzuhara-cho
Itami-shi Hyogo-ken (JP)**

(74) Representative: **Wright, Peter David John et al
R.G.C. Jenkins & Co. 12-15, Fetter Lane
London EC4A 1PL (GB)**

## Description

The present invention relates to a semiconductor memory device having an insulated gate field effect transistor (hereinafter referring to as MISFET) as a fundamental element.

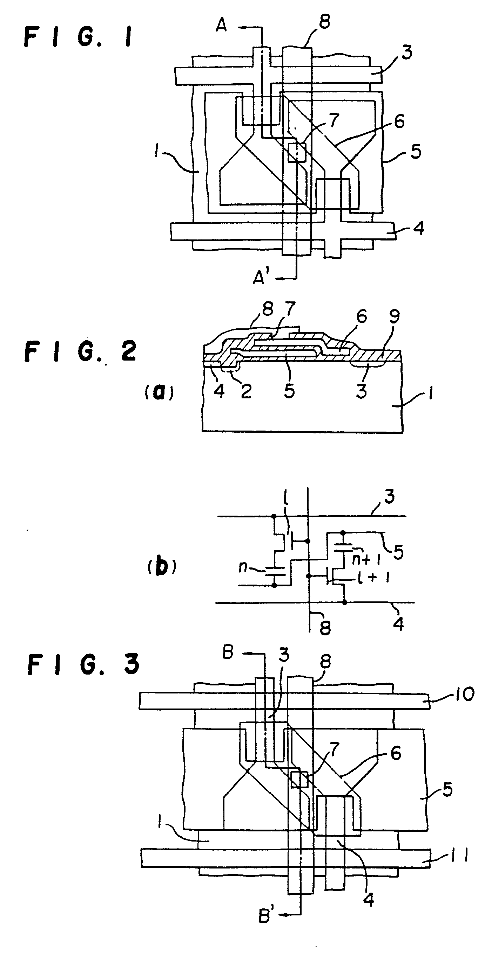

Figure 1 is a plan view of the conventional semiconductor memory device. Figure 2(a) is a sectional view taken along line A—A' in Figure 1, and Figure 2(b) is an equivalent circuit diagram of the device. In the drawings, the reference (1) designates a P type semiconductor substrate; (2) designates a low resistance P type semiconductor region which is selectively formed on one main surface of the P type semiconductor substrate (1) to prevent an electrical connection between MISFETs; (3) and (4) respectively designate N type semiconductor for m th and m+1 th bit lines; (5) designates a first layer of polycrystal silicon for one electrode of MIS capacitors (n) and (n+1) (Figure 2(b)); (6) designates a second layer of polycrystal silicon for switching transistors (I) and (I+1) (Figure 2(b)); (7) designates a contact hole for electrical connection between the second layer of polycrystal silicon (6) and an aluminum wire (8) as a word line; and (9) designates an oxide layer.

The operation of the conventional semiconductor memory device having this structure will now be illustrated. The m th bit line will be especially illustrated.

When the aluminum wire (8) as the word line is at a high potential, the switching transistors (I) and (I+1) are ON. In this case, if the m th bit line (3) is at a high potential the MIS capacitor (n) changes to a high potential whereas if the bit line is at low potential, the capacitor (n) changes to a low potential. In this case, the first polycrystal silicon layer (5), acting as one of the electrodes of the MIS capacitor (n), is biased to the highest potential for the memory device. Then, if the potential of the aluminum word line wire (8) is reduced to a low potential, preferably zero volts, the switching transistor (I) turns OFF to store the potential charged on the MIS capacitor (n). This results in write-in and storage of the data for memory.

The read-out of the data will be carried out as follows.

When the aluminum word line wire (8) is changed to a high potential, the following potential change results in the m th bit line.

$$\Delta V = V - V_p = \frac{Vs - Vp}{1 + Cb/Cs} \qquad (1)$$

wherein Cs designates the capacitance of the MLS capacitor (n); Cb designates the capacitance of the m th bit line; Vs designates the stored potential; Vp designates the original potential of the bit line; V designates the resultant potential of the bit line; and $\Delta V$ designates a difference between potential V and Vp. If Vs=OV In the memory condition of the data, the following equation is given:

$$\Delta V_0 = V - Vp = -Vp/(1 + \frac{Cb}{Cs}) \qquad (2)$$

If Vs=Vcc, the following equation is given:

$$\Delta V_1 = V - Vp = Vcc = Vp/(1 + \frac{Cb}{Cs}) \qquad (3)$$

wherein Vcc >> Vp.

The read-out potential difference between Vs=0 and Vs=Vcc is given by the equation:

$$\Delta V_1 - \Delta V_0 = \frac{Vcc - Vp}{1 + Cb/Cs} - (-\frac{Vp}{1 + Cb/Cs}) = \frac{Vcc}{1 + Cb/Cs}$$

$$(4)$$

This value is the difference in the read-out signal which discriminates between data "1" and data "0". The small potential, such as $\Delta V_1 - V_0 = 0.25V$ is Vcc=5V and Cb/Cs=19, is amplified by an amplifier connected to the bit line and the data are read out of the semiconductor memory device.

Thus the conventional semiconductor memory device has the following disadvantages.

(A) The bit line capacitance (Cb) is the capacitance of the junction of the N type semiconductor line and the P type substrate and is usually large, whereby Cb/Cs is large, resulting in a small read-out potential difference given by equation (4).

(B) The bit line is made by a N—P junction. For example, if α-rays from the package strike the bit string, the electrons generated are stored in the bit line and vary the potential of the bit line, and cause erroneous operation.

(C) A gate length of the switching transistor (I), (I+1) varies depending upon differences in production.

An article by K. L. Rideout in IEEE Transactions on Electron Devices, Vol. ED-26 No. 6 June 1979 pages 839 to 852 discusses a number of designs for insulated gate f.e.t. memory cells. In Figure 12 and section III J a double layer polysilicon cell with polysilicon bit lines is disclosed. In this, a first polysilicon layer provides the capacitor electrode in a similar manner to the electrode (5) of Figure 1 of the present application, and a second polysilicon layer provides the gates in a similar manner to the gate (6) of Figure 1 of the present application. Additionally, the first polysilicon layer provides the bit lines. This is said to reduce the bit-line capacitance.

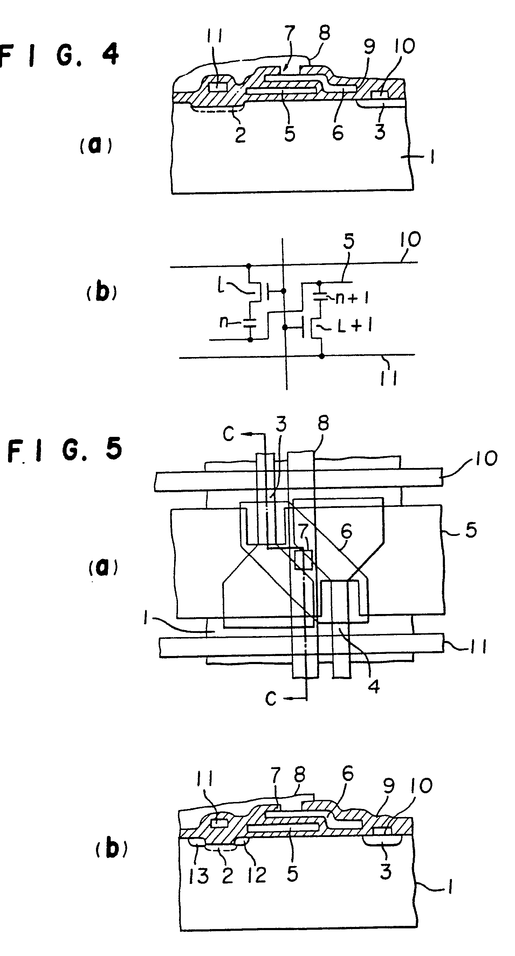

Figure 3 is a plan view of a cell which is not an embodiment of the present invention, but which is the cell of Figures 1 and 2 modified by the use of polycrystal bit lines. Figure 4(a) is a sectional view taken along line B—B' in Figure 3, and Figure 4(b) is an equivalent circuit diagram of the cell of Figure 3.

In Figures 3 and 4, the reference (10) designates a first polycrystal silicon layer which is electrically connected to the N type semiconductor region (3) to form the m th bit line; (11) designates a first polycrystal silicon layer which is electrically connected to the N type semiconductor region (4) to form the m+1 th bit line. Thus, the electric connection between the N type semiconductor region (3) and the m th bit line of the first polycrystal silicon layer and the electric connection between the N type semiconductor region (4) and the m+1 th bit line of the first polycrystal silicon layer are respectively direct connections without using aluminum. The N type semiconductor region (4) is provided only in the regions of electrical connection to the first polycrystal silicon layer. As shown in Figure 4(a), most of the region is covered by the oxide layer (9).

The operation of the semiconductor memory device having this structure is the same as that of Figure 1. In this case, it provides $C_{B2}$ $C_{B1}$ wherein $C_{B1}$ designates the capacitance of the bit line shown in Figure 1 and $C_{B2}$ designates the capacitance of the bit line shown in Figure 3. Also, $C_{s2} \approx C_{s1}$ wherein $C_{s1}$ designates the capacitance of MIS capacitors n and n+1 shown in Figure 1 and $C_{s2}$ designates the capacitance of MIS capacitors n and n+1 shown in Figure 3. Therefore, the capacitance of the bit line is reduced and a larger read-out potential difference is given, which is more easily amplified.

The part of the bit line which is N type semiconductor is quite small and most of the line is made of the first polycrystal silicon layer on the oxide layer, whereby the collection of electrons generated by α-rays is reduced, so that erroneous operation is less easily caused.

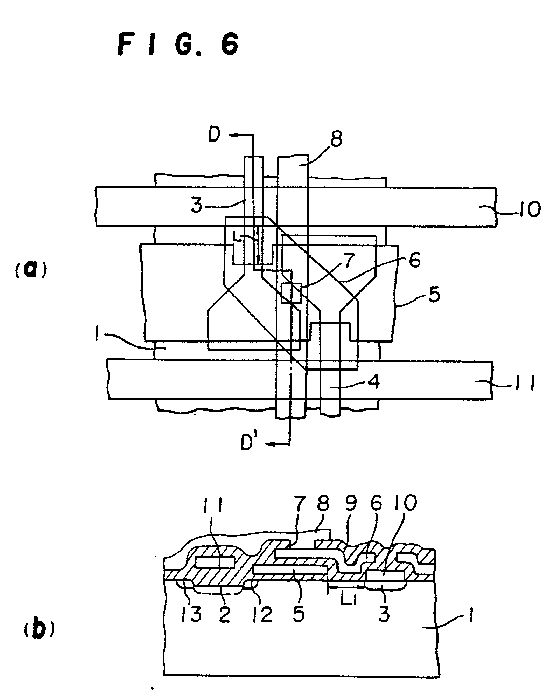

The article in IEEE Transactions mentioned above also discusses the lower capacitor electrode of the memory cell in sections III A and III C with reference to Figures 3 to 6 of the article, which show metal gate, hybrid and single polysilicon layer cells. In the metal gate and the hybrid cells, the lower capacitance electrode is shown as an n type diffusion, while in the single polysilicon layer cell of Figure 6 of the article the electrode is an inversion charge layer of electrodes in the p type substrate developed by biasing the polysilicon electrode to a large positive bias.

It is stated that inversion storage is commonly used in 4 k-bit single polysilicon layer and 16 k-bit double polysilicon layer dynamic RAMs, while in contrast metal gate cells usually use diffusion storage. However, it is also disclosed that in one commercial polysilicon gate 4 k-bit RAM an additional masking step was used deliberately to provide an n-type implant in the capacitor region, thereby converting an otherwise inversion storage capacitor into a depletion storage capacitor.

According to the present invention there is provided a semiconductor memory device having a capacitive storage cell comprising a capacitor (n) a first plate of which is provided in the form of an inversion region at the surface of the semiconductor substrate connected to a bit-line through an insulated gate field effect transistor, the device comprising first and second polycrystal silicon layers, the first polycrystal silicon layer providing the said bit-line and the other electrode plate of the capacitor (n) and the second polycrystal silicon layer (6) providing the gate electrode of the said insulated gate field effect transistor (I), characterised in that the capacitance of the cell is increased by the junction capacitance provided by an additional N-type region which extends the effective area of the said capacitor (n) beyond the limit of the said electrode plate provided by the first polycrystal silicon layer.

Preferably the bit-line provided by said first polycrystal silicon layer is in direct electrical connection with an n-type semiconductor region of the field effect transistor (I).

It is also advantageous if said second polycrystal silicon layer partially overlies the bit-line provided by said first polycrystal silicon layer.

Embodiments of the present invention, given by way of example, will now be described with reference to the accompanying drawings, in which:

Figure 1 is a plan view of a conventional semiconductor memory device;

Figure 2(a) and 2(b) are respectively a sectional view taken along line A—A' of Figure 1 and an equivalent circuit diagram of the device of Figure 1;

Figure 3 is a plan view of a semiconductor memory device (which is not an embodiment of the present invention) having polycrystal silicon bit lines;

Figures 4(a) and 4(b) are respectively a sectional view taken along line B—B' of Figure 3 and an equivalent circuit diagram of the device of Figure 3;

Figures 5(a) and 5(b) are respectively a plan view of a first embodiment of the present invention and a sectional view taken along line C—C'; and

Figures 6(a) and 6(b) are respectively a plan view of a second embodiment of the present invention and a sectional view taken along line D—D'.

In the embodiments shown, the first polycrystal silicon layer provides the capacitor electrode and the bit lines and the second polycrystal silicon layer provides the gate electrode of the insulated gate field effect transistor.

In Figures 5, the references (12) and (13) respectively designate additional N type regions which provide junction capacitors and which are connected to expand the area of the memory capacitor ($C_{s2}$) over the area in the device of Figures 3 and 4. Thus, the junction capacitance between the additional N⁺ region and the P type semiconductor substrate can be added in parallel to the MIS capacitors (m) and (m+1) to increase the memory capacitance ($C_{s2}$). This reduces the

ratio Cb/Cs. The distance between the electrode plate (5) of the first polycrystal silicon layer and the m th bit line (10) or the m+1 th bit line (11) of the first polycrystal silicon layer cannot be reduced to less than a certain distance which depends upon the conditions of preparation.

In the embodiment of Figures 6(a) and 6(b) the second polycrystal silicon layer for the gates of the switching transistors (I) and (I+1) partially covers the m th bit line (10) and the m+1 th bit line (11) of the first polycrystal silicon layer, whereby the gate lenths (L) can be kept constant positioning of the regions of the switching transistor are not uniform. Thus, the gate lengths of the switching transistors can be always kept constant regardless of nonuniformity in the preparation (especially caused by deviation of superpositioning of a mask), whereby deterioration of characteristics of the switching transistor caused by nonuniformity of the gate lengths (fluctuation of barrier voltages; fluctuation of withstand voltages; and fluctuation of foot current) is avoided to give stable characteristics.

The operation of this device is the same as those of Figures 1, 3 and 5.

## Claims

1. A semiconductor memory device having a capacitive storage cell comprising a capacitor (n) a first plate of which is provided in the form of an inversion region at the surface of the semiconductor substrate connected to a bit-line through an insulated gate field effect transistor, the device comprising first and second polycrystal silicon layers (5, 10, 6), the first polycrystal silicon layer (5, 10) providing the said bit-line and the other electrode plate of the capacitor (n) and the second polycrystal silicon layer (6) providing the gate electrode of the said insulated gate field effect transistor (I), characterised in that the capacitance of the cell is increased by the junction capacitance provided by an additional N-type region (12) which extends the effective area of the said capacitor (n) beyond the limit of the said electrode plate (5) provided by the first polycrystal silicon layer.

2. A semiconductor memory device according to claim 1 characterised in that the bit-line provided by said first polycrystal silicon layer (5, 10) is in direct electrical connection with an N-type semiconductor region (3) of the field effect transistor (I).

3. A semiconductor memory device according to claim 1 or 2, characterised in that said second polycrystal silicon layer (6) partially overlies the bit-line provided by said first polycrystal silicon layer (5, 10).

## Patentansprüche

1. Halbleiterspeichereinrichtung mit einer kapazitiven Speicherzelle umfassend einen Kondensator (n), dessen erste Platte in Form einer Inversionsregion an der Oberfläche des Halbleitersubstrats vorliegt, das über einen Feldeffekttransistor mit isoliertem Gate mit einer Bit-Leitung verbunden ist, wobei die Einrichtung erste und zweite Schichten (5, 10, 6) aus polykristallinem Silicium umfaßt, wobei die erste Schicht (5, 10) aus polykristallinem Silicium die Bit-Leitung bildet und wobei die andere Elektrodenplatte des Kondensators (n) und die zweite Schicht (6) aus polykristallinem Silicium die Gateelektrode des Feldeffekttransistors (I) mit isoliertem Gate bilden, dadurch gekennzeichnet, daß die Kapazität der Zelle erhöht wird durch die Sperrschichtkapazität, welche gebildet wird durch eine zusätzliche Region (12) vom N-Typ, die die effektive Fläche des Kondensators (n) über die Grenze der Elektrodenplatte (5) der ersten Schicht aus polykristallinem Silicium ausdehnt.

2. Halbleiterspeichereinrichtung nach Anspruch 1, dadurch gekennzeichnet, daß die durch die erste Schicht aus polykristallinem Silicium (5, 10) gebildete Bit-Leitung in direkter elektrischer Verbindung mit der Haltleiterregion (3) vom N-Typ des Feldeffekttransistors (I) steht.

3. Halbleiterspeichereinrichtung nach Anspruch 1 oder 2, dadurch gekennzeichnet, daß die zweite Schicht (6) aus polykristallinem Silicium die durch die erste Schicht (5, 10) aus polykristallinem Silicium gebildete Bit-Leitung partiell überlagert.

## Revendications

1. Dispositif de mémoire à semiconducteurs comportant une cellule de stockage capacitive comprenant un condensateur (n) dont une première plaque est prévue sous la forme d'une région d'inversion à la surface du substrat semicooinducteur raccordé à une ligne de transmission de bits par l'intermédiaire d'un transistor à effet de champ à grille isolée, le dispositif comprenant des première et seconde couches de silicium polycristallin (5, 10, 6), la première couche de silicium polycristallin (5, 10) fournissant ladite ligne de transmission de bits et l'autre plaque d'électrode du condensateur (n), et la seconde couche de silicum polycristallin (6) fournissant l'électrode de grille dudit transistor à effet de champ à grille isolée (I), caractérisé en ce que la capacité de la cellule est accrue par la capacité de la jonction fournie par une région supplémentaire de type N (12), qui accroît la surface effective dudit condensateur (n) au-delà de la limite de ladite plaque d'électrode (5) fournie par la première couche de silicium polycristallin.

2. Dispositif de mémoire à semiconducteurs selon la revendication 1, caractérisé en ce que la ligne de transmission de bits formée par ladite première couche de silicium polycristallin (5, 10) est en liaison électrique directe avec une région semiconductrice de type N (3) du transistor à effet de champ (I).

3. Dispositif de mémoire à semiconducteurs selon la revendication 1 ou 2, caractérisé en ce que ladite seconde couche de silicium polycristallin (6) recouvre partiellement la ligne de transmission de bits formée par ladite première couche de silicium polycristallin (5, 10).

F I G. 1

F I G. 2

(a)

(b)

F I G. 3

1

F I G. 4

(a)

(b)

F I G. 5

(a)

(b)

# F I G. 6

(a)

(b)